# EUROPEAN PATENT APPLICATION

(11) **EP 4 518 088 A1**
(43) Date of publication of application: **05.03.2025**
(21) Application number: 23877463.2
(22) Date of filing: 22.08.2023
(51) Int. Cl.: H02J 7/00, H01M 10/44, G01R 31/382, G01R 31/374

(54) **BATTERY FAST-CHARGING DEVICE AND METHOD**

(30) Priority: 11.10.2022 KR 20220129626
(71) Applicant: LG Energy Solution, Ltd., Seoul 07335 (KR)
(72) Inventor: KIM, Taesoo, Daejeon 34122 (KR)
(74) Representative: Plasseraud IP
(86) International application number: PCT/KR2023/012391
(87) International publication number: WO 2024/080533

(57) **Abstract**

The apparatus and method for fast charging of a battery according to aspects of the disclosure may add a compensation current considering the current gain according to initial state of charge of the battery to the existing charge current of the battery obtained by considering only the temperature and real-time state of charge of the battery and supply it to the battery, thereby shortening fast charging time.

## Description

### [Technical Field]

This application claims priority to and the benefit of Korean Patent Application No.10-2022-0129626 filed in the Korean Intellectual Property Office on October 11, 2022, the entire contents of which are incorporated herein by reference.

The technology relates to an apparatus and method for fast charging of a battery, and more particularly, to an apparatus and method for fast charging of a battery by measuring initial charge amount of a battery and reflecting a corresponding compensation current.

### [Background]

As the price of energy sources rises due to depletion of fossil fuels and interest in environmental pollution increases, a demand for secondary batteries as an eco-friendly alternative energy source is rapidly increasing.

Due to the fact that secondary batteries can be repeatedly charged and regenerated, the secondary batteries are being applied to large industrial fields such as automobiles, robots, and energy storage devices, as well as small devices such as mobile phones and laptops as a response to today's environmental regulations and high oil price issues.

Among secondary batteries, lithium secondary batteries are attracting attention due to their advantages such as little memory effect, low selfdischarge rate, and high energy density compared to nickel-based secondary batteries.

As the frequency of use of lithium batteries increases, fast/quick charging technology has been introduced to rapidly charge the battery.

Conventional quick charging technology uses a way of quick charge map to obtain information on a magnitude of charge current for quick charging based on the temperature and the state of charge (SOC) of the battery to be charged, thereby rapidly charging the battery.

However, since the conventional quick charge map does not consider initial state of charge of the battery to be charged, the charge current is limited when the initial state of charge of the battery exceeds the lowest section of the state of charge, even though it is possible to charge the battery with a charge current exceeding the upper limit of current defined in the quick charge map without lithium plating, which leads to a disadvantage of lowering efficiency.

### [Summary]

### [Technical Problem]

Aspects of the disclosure provide for an apparatus for fast charging of a battery.

Aspects of the disclosure also provide for a method for fast charging of a battery.

### [Technical Solution]

An aspect of the disclosure provides for an apparatus for fast charging of a battery, the apparatus may include at least one processor; and a memory configured to store at least one instruction executed by the at least one processor, wherein the at least one instruction may include an instruction to identify an initial state of charge (SOC) of the battery to be charged; an instruction to calculate a magnitude of an initial charge current based on the initial state of charge of the battery; and an instruction to provide the calculated magnitude of the initial charge current to the battery so as to rapidly charge the battery.

Here, the instruction to calculate the magnitude of initial charge current may include an instruction to calculate the magnitude of the initial charge current of the battery based on a quick charge map defining an upper limit of current according to the initial state of charge of the battery and a compensation current map defining a compensation current according to the initial state of charge of the battery.

The instruction to calculate the magnitude of initial charge current may include an instruction to identify a magnitude of the upper limit of current according to the initial state of charge of the battery using the quick charge map; an instruction to identify a magnitude of the compensation current according to the initial state of charge of the battery using the compensation current map; and an instruction to calculate the magnitude of the initial charge current based on the magnitude of the upper limit of current and the magnitude of the compensation current.

Furthermore, the magnitude of the initial charge current may be a sum of the upper limit of current and the magnitude of the compensation current.

Meanwhile, the instruction to identify the initial state of charge of the battery may further include an instruction to check a real-time state of charge of the battery.

In addition, the at least one instruction may further include an instruction to monitor the real-time state of charge of the battery; and an instruction to, upon an upper limit of current in a quick charge map being changed according to a change in the real-time state of charge of the battery, provide a charge current corresponding to a magnitude of the changed upper limit of current to the battery for rapidly charging the battery.

An aspect of the disclosure provides for, a method for fast charging of a battery may include identifying an initial state of charge (SOC) of the battery to be charged; calculating a magnitude of an initial charge current based on the initial state of charge of the battery; and providing the calculated magnitude of the initial charge current to the battery so as to rapidly charge the battery.

Here, the calculating the magnitude of initial charge current may include calculating the magnitude of the initial charge current of the battery based on a quick charge map defining an upper limit of current according to the initial state of charge of the battery and a compensation current map defining a compensation current according to the initial state of charge of the battery.

The calculating the magnitude of initial charge current may include identifying a magnitude of the upper limit of current according to the initial state of charge of the battery using the quick charge map; identifying a magnitude of the compensation current according to the initial state of charge of the battery using the compensation current map; and calculating the magnitude of the initial charge current based on the magnitude of the upper limit of current and the magnitude of the compensation current.

Furthermore, the magnitude of the initial charge current may be a sum of the upper limit of current and the magnitude of the compensation current.

The identifying the initial state of charge of the battery further includes checking a real-time state of charge of the battery.

In addition, the method may further include monitoring the real-time state of charge of the battery; and, upon an upper limit of current in a quick charge map being changed according to a change in the real-time state of charge of the battery, providing a charge current corresponding to a magnitude of the changed upper limit of current to the battery for rapidly charging the battery.

### [Advantageous Effects]

The apparatus and method for fast charging of a battery according to aspects of the disclosure may add a compensation current considering the current gain according to initial state of charge of the battery to the existing charge current of the battery obtained by considering only the temperature and real-time state of charge of the battery and supply it to the battery, thereby shortening fast charging time.

### [Brief Description of the Drawings]

FIG. 1 is a table of a quick charge map used in a general device for fast charging of a battery.
FIG. 2 is a block diagram of an apparatus for fast charging of a battery according to aspects of the disclosure.
FIG.3 is a flowchart for explaining a method for fast charging of a battery which may be performed by a processor in an apparatus for fast charging of a battery according to aspects of the disclosure.
FIG. 4 is a flowchart illustrating a method for calculating the initial charge current of the battery rapid charging method according to aspects of the disclosure.
FIG. 5 is a table of the compensation current map of the method for fast charging of a battery according to aspects of the disclosure.

100: memory 200: processor
300: transceiver 400: input interface device
500: output interface device 600: storage device
700: bus

### [Detailed Description]

The disclosure may be modified in various forms and have various aspects, and specific aspects thereof are shown by way of example in the drawings and will be described in detail below. It should be understood, however, that there is no intent to limit the disclosure to the specific aspects, but on the contrary, the disclosure is to cover all modifications, equivalents, and alternatives falling within the spirit and technical scope of the disclosure. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the disclosure. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

Terms used in the present application are used only to describe specific aspects, and are not intended to limit the disclosure. A singular form includes a plural form if there is no clearly opposite meaning in the context. In the present application, it should be understood that the term "include" or "have" indicates that a feature, a number, a step, an operation, a component, a part or the combination thereof described in the specification is present, but does not exclude a possibility of presence or addition of one or more other features, numbers, steps, operations, components, parts or combinations thereof, in advance.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

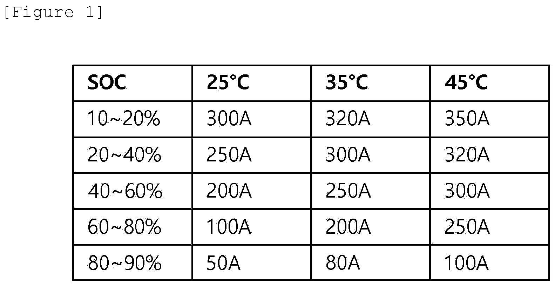

FIG. 1 is a table of a quick charge map used in a general device for fast charging of a battery.

Referring to FIG. 1, a general device for fast charging of a battery charges a battery rapidly using a quick charge map that provides a limit current for each charge section according to the temperature.

To be more specific, a general device for fast charging of a battery monitors the temperature and state of charge of the battery and provides a charge current which is the upper limit value in a corresponding section of the quick charge map to the battery, based on the monitoring information. Accordingly, the battery can be rapidly charged.

The upper limit value of current provided in the quick charge map may be a magnitude of the limit current to prevent lithium plating that may occur on a negative surface of the battery during fast charging. In other words, the limit current may be an upper limit value of current which is set to prevent lithium plating during rapid charging.

Here, the magnitude of the limit current may vary depending on not only the temperature and the state of charge of the battery, but also initial state of charge of the battery.

The limit current value may increase as the initial state of charge of the battery increases.

However, the general quick charge map does not consider the initial state of charge of the battery to be charged, but provides a limit current for each temperature assuming the initial state of charge of the battery as the lowest section of the state of charge. Accordingly, in a general device for fast charging of a battery that provides charge current using a quick charge map, the charge current is limited when the initial state of charge of the battery exceeds the lowest section of the state of charge, even though it is possible to charge the battery with a charge current exceeding the upper current limit defined in the quick charge map without lithium plating, which leads to a disadvantage of lowering efficiency.

Accordingly, aspects of the disclosure provide for a battery rapid charging device and method that takes into account initial state of charge of the battery and reflects a compensation current accordingly during initial charging of the battery.

Hereinafter, aspects of the disclosure will be described in detail with reference to the accompanying drawings.

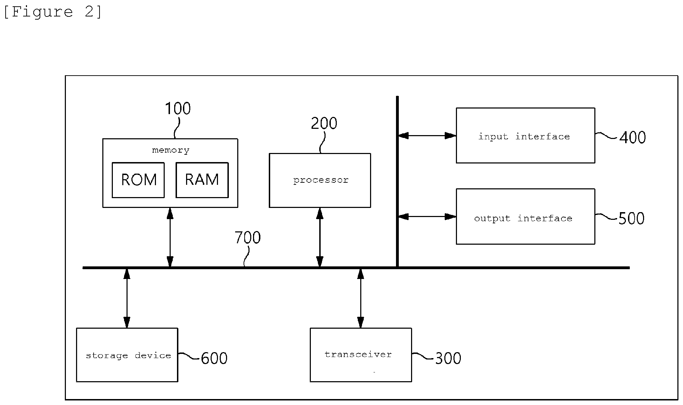

FIG. 2 is a block diagram of an apparatus for fast charging of a battery according to aspects of the disclosure.

Referring to FIG. 2, the apparatus for fast charging of a battery may provide charge current considering initial state of charge (hereinafter SOC) of the battery to be charged using a fast charge map and a compensation current map.

In more detail as to each component of the apparatus for fast charging of a battery, the apparatus for fast charging of a battery may include a memory 100, a processor 200, a transceiver 300, an input interface 400, an output interface 500, and a storage device 600.

Respective components 100, 200, 300, 400, 500, 600 included in the battery charging control apparatus may be connected by a bus 700 to communicate with each other.

The memory 100 and the storage device 600 among the components 100, 200, 300, 400, 500, 600 may include at least one of a volatile storage medium and a non-volatile storage medium. For example, the memory 100 and the storage device 600 may include at least one of read only memory (ROM) and random access memory (RAM).

Among them, the memory 100 may include at least one instruction executed by the processor 200.

The at least one instruction may include an instruction to identify an initial state of charge (SOC) of the battery to be charged; an instruction to calculate a magnitude of an initial charge current based on the initial state of charge of the battery; and an instruction to provide the calculated magnitude of the initial charge current to the battery so as to rapidly charge the battery.

The instruction to calculate the magnitude of initial charge current may include an instruction to calculate the magnitude of the initial charge current of the battery based on a quick charge map defining an upper limit of current according to the initial state of charge of the battery and a compensation current map defining a compensation current according to the initial state of charge of the battery.

The instruction to calculate the magnitude of initial charge current may include an instruction to identify a magnitude of the upper limit of current according to the initial state of charge of the battery using the quick charge map; an instruction to identify a magnitude of the compensation current according to the initial state of charge of the battery using the compensation current map; and an instruction to calculate the magnitude of the initial charge current based on the magnitude of the upper limit of current and the magnitude of the compensation current.

The magnitude of the initial charge current may be a sum of the upper limit of current and the magnitude of the compensation current.

The instruction to identify the initial state of charge of the battery may further include an instruction to check a real-time state of charge of the battery.

The at least one instruction may further include an instruction to monitor the real-time state of charge of the battery; and an instruction to, upon an upper limit of current in a quick charge map being changed according to a change in the real-time state of charge of the battery, provide a charge current corresponding to a magnitude of the changed upper limit of current to the battery for rapidly charging the battery.

Meanwhile, the processor 200 may mean a central processing unit (CPU), a graphics processing unit (GPU), or a dedicated processor on which methods according to aspect of the disclosure are performed.

The processor 200 may execute at least one program command stored in the memory 100 as described above.

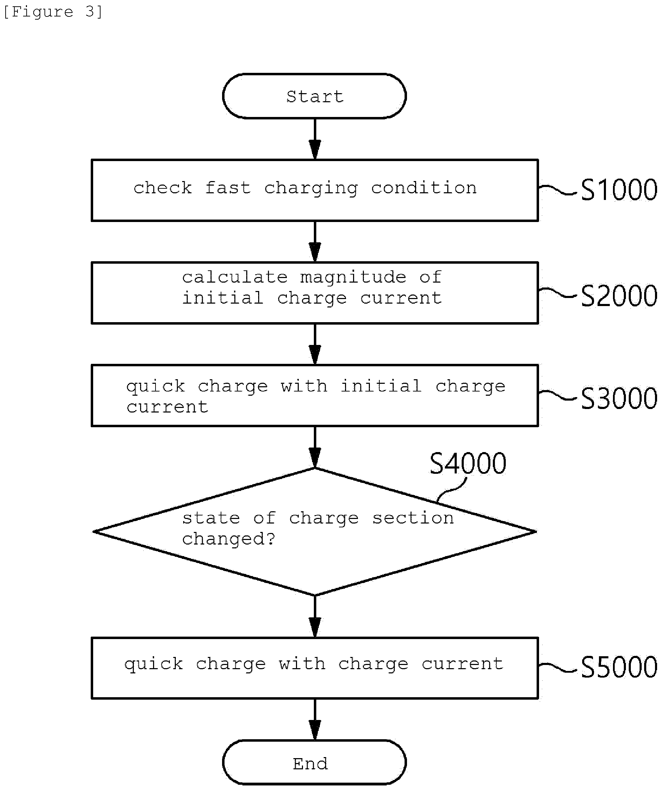

FIG.3 is a flowchart for explaining a method for fast charging of a battery which may be performed by a processor in an apparatus for fast charging of a battery according to aspect of the disclosure.

Referring to FIG. 3, the apparatus for fast charging of a battery may check a fast charging condition by operations of the processor 200 (S1000).

Here, the fast charging condition may be a condition of at least one battery required to determine a magnitude of charge current for fast charging the battery. The fast charging condition may include an initial state of charge of the battery to be charged and temperature information of the battery.

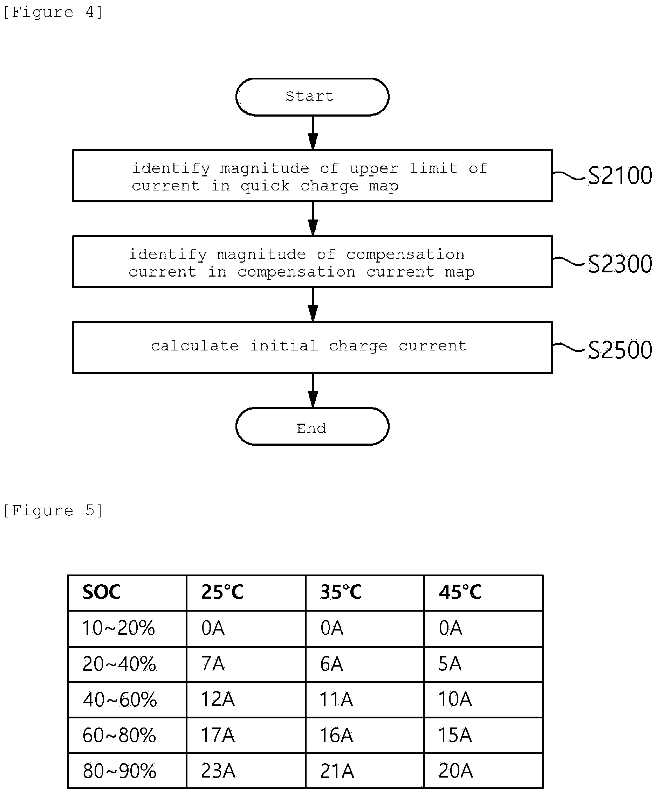

Thereafter, the apparatus for fast charging of a battery may calculate the magnitude of the initial charge current (S2000). Here, the initial charge current may be a magnitude of the charge current that satisfies the fast charging condition of the battery to be fast charged. The method of calculating the initial charge current will be described with reference to FIGS. 4 and 5 below.

FIG. 4 is a flowchart illustrating a method for calculating the initial charge current of the battery rapid charging method according to aspect of the disclosure.

Referring to FIG. 4, the apparatus for fast charging of a battery may use a quick charge map to identify the magnitude of the upper limit of current according to the state of charge at a corresponding temperature (S2100).

Here, the quick charge map may be a table that divides the state of charge of the battery into a certain range of sections and defines an upper limit of current at a certain temperature. More specifically, the quick charge map may provide 5 sections as to state of charge ranges of the battery, from 10% to less than 20%, from 20% to less than 40%, from 40% to less than 60%, from 60% to less than 80%, and from 80% to less than 90%, and may provide upper limits of current for each corresponding state of charge section, at 25°C, 35°C, and 45°C.

For example, the quick charge map may be the same as the quick charge map provided by a general battery charging device disclosed in FIG. 1.

Thereafter, the apparatus for fast charging of a battery may use a compensation current map to identify a magnitude of compensation current according to the state of charge at a corresponding temperature (S2300).

Aspect of the disclosure may additionally provide a compensation current which compensates a difference between the upper limit of current according the quick charge map and the limit current at which lithium does not precipitate considering the initial state of charge of the battery.

FIG. 5 is a table of the compensation current map of the method for fast charging of a battery according to aspect of the disclosure.

Referring to FIG. 5, the compensation current map may be a table that provides a magnitude of compensation current for each temperature according to initial state of charge of the battery in order to consider current gain according to the initial state of charge of the battery which is not considered in the fast charge map.

More specifically, as explained earlier, the quick charge map assumes the initial state of charge of the battery before charging to be the lowest range of 10%, and then provides a current limit that is defined by considering only the temperature and real-time state of charge of the battery to be charged.

Accordingly, the method for fast charging of a battery may identify the magnitude of the compensation current according to the initial state of charge of the battery according to the compensation current map in addition to the upper limit of the quick charge map, when the initial state of charge of the battery to be charged exceeds the minimum state of charge section, that is, when the initial state of charge of the battery is 20% or more.

The compensation current value increases as the initial state of charge (SOC) of the battery increases in the compensation current map.

Referring again to FIG. 4, the apparatus for fast charging of a battery may calculate an initial charge current based on the magnitude of the upper limit of current in the quick charge map and the magnitude of the compensation current according to the compensation current map (S2500). The initial charge current may be a sum of the upper limit of current and a compensation current corresponding to the temperature and the initial charge state of the battery to be charged.

For example, when the temperature of the battery to be charged is 35°C and the state of charge is 50%, the apparatus for fast charging of a battery may obtain 250A as the upper limit of current through the rapid charge map. Here, the state of charge of the battery to be charged may be the same as the initial charge state because the battery has not been charged.

Meanwhile, the apparatus for fast charging of a battery may use a compensation current map to obtain a compensation current of 11A under the same quick charging condition (battery temperature 35°C, initial state of charge 50%).

Accordingly, the apparatus for fast charging of a battery may calculate a total of 265A as the initial charge current by adding 250A which is the upper limit of current and 11A which is the magnitude of the compensation current.

Referring again to FIG. 3, the apparatus for fast charging of a battery may quick charge the battery by providing an initial charge current corresponding to the calculated initial charge current information (S3000).

Thereafter, the apparatus for fast charging of a battery may continuously monitor the state of charge of the battery.

When the real-time state of charge section of the battery exceeds the section to which the initial charge state belongs, that is, when the state of charge section of the battery changes (S5000), the apparatus for fast charging of a battery may use a fast charge map to set the magnitude of the upper limit of current corresponding to the real-time state of charge section of the battery as the magnitude of the charge current, and provide the charge current to the battery (S7000).

Thereafter, when the real-time state of charge of the battery changes due to continuous fast charging, the apparatus for fast charging of a battery may charge the battery with a magnitude of the charge current corresponding to the real-time state of charge section of the battery based on the fast charge map, as in step S7000.

The apparatus and method for fast charging of a battery according to aspect of the disclosure have been described above.

The apparatus and method for fast charging of a battery according to aspect of the disclosure may add a compensation current considering the current gain according to initial state of charge of the battery to the existing charge current of the battery obtained by considering only the temperature and real-time state of charge of the battery and supply it to the battery, thereby shortening fast charging time.

The operations of the method according to aspect of the disclosure may be implemented as a computer-readable program or code on a computer-readable recording medium. The computer-readable recording medium includes all types of recording devices in which data readable by a computer system is stored. In addition, the computer-readable recording medium may be distributed in a networkconnected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the disclosure have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An apparatus for fast charging of a battery, the apparatus comprising:
at least one processor; and
a memory configured to store at least one instruction executed by the at least one processor, wherein the at least one instruction comprises:
identifying an initial state of charge of the battery; calculating a magnitude of an initial charge current based on the initial state of charge of the battery; and
providing the calculated magnitude of the initial rapidly charge current to the battery so as to charge the battery.

2. The apparatus of claim 1, wherein calculating the magnitude of initial charge current includes an instruction to calculate the magnitude of the initial charge current of the battery based on a quick charge map defining an upper limit of current according to state of charge of the battery and a compensation current map defining a compensation current according to the initial state of charge of the battery.

3. The apparatus of claim 2, wherein calculating the magnitude of initial charge current further comprises:
identifying a magnitude of the upper limit of current according to the initial state of charge of the battery using the quick charge map;
identifying a magnitude of the compensation current according to the initial state of charge of the battery using the compensation current map; and
calculating the magnitude of the initial charge current based on the magnitude of the upper limit of current and the magnitude of the compensation current.

4. The apparatus of claim 3, wherein the magnitude of the initial charge current is a sum of the upper limit of current and the magnitude of the compensation current.

5. The apparatus of claim 1, wherein identifying the initial state of charge of the battery further comprises checking a real-time state of charge of the battery.

6. The apparatus of claim 5, wherein the at least one instruction further comprises:
monitoring the real-time state of charge of the battery; and
in response to an upper limit of current in a quick charge map being changed according to a change in the real-time state of charge of the battery, providing a charge current corresponding to a magnitude of the changed upper limit of current to the battery so as to rapidly charge the battery.

7. A method for fast charging of a battery, the method comprising:
identifying an initial state of charge of the battery;
calculating a magnitude of an initial charge current based on the initial state of charge of the battery; and
providing the calculated magnitude of the initial charge current to the battery so as to rapidly charge the battery.

8. The method of claim 7, wherein calculating the magnitude of initial charge current includes calculating the magnitude of the initial charge current of the battery based on a quick charge map defining an upper limit of current according to state of charge of the battery and a compensation current map defining a compensation current according to the initial state of charge of the battery.

9. The method of claim 8, wherein the calculating the magnitude of initial charge current further comprises:
identifying a magnitude of the upper limit of current according to the initial state of charge of the battery using the quick charge map;
identifying a magnitude of the compensation current according to the initial state of charge of the battery using the compensation current map; and
calculating the magnitude of the initial charge current based on the magnitude of the upper limit of current and the magnitude of the compensation current.

10. The method of claim 9, wherein the magnitude of the initial charge current is a sum of the upper limit of current and the magnitude of the compensation current.

11. The method of claim 7, wherein identifying the initial state of charge of the battery further comprises checking a real-time state of charge of the battery.

12. The method of claim 11, further comprising:
monitoring the real-time state of charge of the battery; and
in response to an upper limit of current in a quick charge map being changed according to a change in the real-time state of charge of the battery, providing a charge current corresponding to a magnitude of the changed upper limit of current to the battery so as to rapidly charge the battery.
